# EUROPÄISCHE PATENTSCHRIFT

(11) **EP 3 281 240 B1**
(45) Veröffentlichungstag und Bekanntmachung des Hinweises auf die Patenterteilung: **27.02.2019**
(21) Anmeldenummer: 16727289.7
(22) Anmeldetag: 05.04.2016
(51) Int. Cl.: H01M 2/10

(54) **SCHALTSCHRANK ODER RACK ZUR AUFNAHME ELEKTRISCHER ENERGIESPEICHER, INSBESONDERE BATTERIEN, UND EINE ENTSPRECHENDE SCHALTSCHRANK- ODER RACKANORDNUNG**
RACK FOR RECEIVING ELECTRICAL STORAGE DEVICES INCLUDING BATTERIES AND A CORRESPONDING LAYOUT
RACK POUR RECEVOIR DES ÉLÉMENTS DE STOCKAGE D'ÉNERGIE ÉLECTRIQUE, COMPRENANT LES PILES ET UN ARRANGEMENT ASSOCIÉ

(30) Priorität: 10.04.2015 DE 102015105482
(43) Veröffentlichungstag der Anmeldung: 14.02.2018
(73) Patentinhaber: Rittal GmbH & Co. KG, 35745 Herborn (DE)
(72) Erfinder: BACH, Michael, 35768 Siegbach (DE)
(74) Vertreter: Angerhausen, Christoph
(86) Internationale Anmeldenummer: PCT/DE2016/100158
(87) Internationale Veröffentlichungsnummer: WO 2016/162018

(56) Entgegenhaltungen:
- DE-U1-202009 005 875
- US-A1- 2005 236 944
- US-A1- 2006 028 171

## Beschreibung

Die Erfindung geht aus von einem Schaltschrank oder Rack zur Aufnahme elektrischer Energiespeicher, insbesondere Batterien, wobei der Schaltschrank oder das Rack eine Mehrzahl übereinander angeordneter Energiespeichereinschübe aufweist, die von einer Mehrzahl von Nuten gebildet sind, deren Längs- und Einschubrichtung sich in Tiefenrichtung des Schaltschranks oder Racks erstreckt, und wobei jeweils ein Paar der Nuten an gegenüber liegenden Seiten des Schaltschranks oder Racks auf derselben vertikalen Höhe und mit ihrer offenen Längsseite aufeinander zu gerichtet sind. Eine derartige Vorrichtung ist aus der DE 20 2009 005875 U1 bekannt. Ähnliche Vorrichtungen sind außerdem in der US 2005/236944 A1 und der US 2006/028171 A1 beschrieben.

Ein weiterer Schaltschrank ist beispielsweise aus der US 8,900,737 B2 bekannt. Dieser weist eine Mehrzahl über Trennböden voneinander separierter Gefache auf, in denen jeweils elektrische Energiespeicher aufgenommen werden können. Einen ähnlichen Schaltschrank offenbaren auch die EP 1 462 813 A2, die EP 1 355 404 B1, die EP 2 731 166 A1, die WO 03/019703 A1, die WO 2005/074097 A2 und die WO 02/027817 A1.

Die bekannten Schaltschränke haben den Nachteil, dass sie aufgrund der Verwendung von Trennböden zur Separierung der Gefache vergleichsweise aufwändig gestaltet sind, wobei die Trennböden selbst Bauraum im Innern des Schaltschranks einnehmen, der folglich nicht für die Aufnahme von elektrischen Energiespeichern genutzt werden kann.

Es ist daher die Aufgabe der Erfindung, einen Schaltschrank der eingangs erwähnten Art derart weiterzuentwickeln, dass er mit möglichst einfachen technischen Mitteln zugleich die Aufnahme einer Vielzahl elektrischer Energiespeicher bei hoher Packungsdichte erlaubt.

Diese Aufgabe wird erfindungsgemäß durch einen Schaltschrank oder ein Rack mit den Merkmalen des Anspruchs 1 gelöst. Der nebengeordnete Anspruch 9 betrifft eine entsprechende Schaltschrank- oder Rackanordnung. Die abhängigen Ansprüche betreffen jeweils vorteilhafte Ausführungsformen der Erfindung.

Demgemäß weisen bei einem Schaltschrank oder Rack die Energiespeichereinschübe jeweils an ihrem in Einschubrichtung hinteren Ende einen Masseanschluss auf, der einen Massekontakt eines Energiespeichers kontaktiert, wenn sich der betreffende Energiespeicher in einer vollständig eingeschobenen Position befindet, wobei der Schaltschrank oder das Rack weiterhin ein elektrisch leitfähiges Rahmengestell aufweist, an dem die, ebenfalls elektrisch leitfähigen, Energiespeichereinschübe, insbesondere die die Energiespeichereinschübe bildenden Montagechassis, montiert und elektrisch kontaktiert sind, wobei die Masseanschlüsse mit den Energiespeichereinschüben, insbesondere mit den Montagechassis, elektrisch kontaktiert sind.

Durch die Bereitstellung von Nuten zur Aufnahme der Energiespeicher im Innern des Schaltschranks oder Racks kann auf die Verwendung von Trennböden und dergleichen verzichtet werden, so dass der vormals von diesen eingenommene Raum eingespart wird und sich dementsprechend die Packungsdichte der Energiespeicher im Innern des Schaltschranks oder Racks erhöht.

Die Energiespeichereinschübe können von einer Mehrzahl vertikal übereinander und an den gegenüber liegenden Seiten des Schaltschranks oder Racks montierten Montagechassis gebildet sein, die unter einem vertikalen Abstand zueinander montiert sind, der eine vertikale Nutbreite senkrecht zur Einschubrichtung festlegt.

Dabei können die Montagechassis an ihren sich in Tiefenrichtung erstreckenden, parallelen Längsseiten jeweils einen in Richtung der jeweils gegenüber liegenden Seite des Schaltschranks oder Racks abgekanteten Anlageflansch aufweisen.

Die Anlageflansche paarweise gegenüber liegender Montagechassis können auf derselben vertikalen Höhe angeordnet sein, wobei jeweils eine der Nuten zwischen den abgekanteten Anlageflanschen unmittelbar aufeinander folgender Montagechassis gebildet ist.

Weiterhin kann der Schaltschrank oder das Rack ein Rahmengestell mit vier gleich langen Vertikalstreben und vier gleich langen Tiefenstreben aufweisen, von denen jeweils zwei Vertikalstreben und zwei Tiefenstreben zu einem rechteckigen Rahmen verbunden sind. Die Rahmen bilden jeweils die gegenüber liegenden Seiten des Schaltschranks oder Racks, wobei die Vertikalstreben an einer Montageseite eine Systemlochung aus regelmäßig beabstandeten Montageausnehmungen aufweisen, und wobei die Montagechassis an gegenüber liegenden Enden mit jeweils einer der Vertikalstreben eines der rechteckigen Rahmen verbunden sind.

Der Masseanschluss kann dabei ein elektrisch leitfähiges Kontaktblech mit einem Befestigungsabschnitt aufweisen, über den das Kontaktblech an einem der Montagechassis elektrisch leitfähig festgelegt ist, wobei das Kontaktblech weiterhin ein freies Ende aufweist, das gegenüber dem Befestigungsabschnitt mechanisch vorspannbar ist und mindestens eine Kontaktkralle zur elektrischen Kontaktierung des Massekontaktes des Energiespeichers aufweist.

Zur präzisen Definition einer vollständig eingeschobenen Position eines Energiespeichers in einem der Energiespeichereinschübe und somit zur Sicherstellung der elektrischen Kontaktierung zwischen Massekontakt des Energiespeichers und Masseanschluss kann vorgesehen sein, dass die Energiespeichereinschübe jeweils eine Rastposition aufweisen, die eine vollständig eingeschobene Position eines Energiespeichers festlegt, wobei in der Rastposition das freie Ende des Kontaktblechs über die mindestens eine Kontaktkralle an dem Massekontakt des Energiespeichers mechanisch vorgespannt anliegt, um den Masseanschluss elektrisch zu kontaktieren.

Dabei kann es vorteilhaft sein, dass das Rahmengestell aus unlackierten, elektrisch leitfähigen Streben oder aus unlackierten, elektrisch leitfähig beschichteten, insbesondere verzinkten, Streben gebildet ist.

Eine Schaltschrank- oder Rackanordnung kann dementsprechend einen Schaltschrank oder ein Rack der zuvor beschriebenen Art sowie eine Mehrzahl elektrischer Energiespeicher aufweisen, wobei die elektrischen Energiespeicher an gegenüber liegenden Seiten jeweils einen sich in Tiefenrichtung des Energiespeichers erstreckenden Befestigungsflansch aufweisen, über den die elektrischen Energiespeicher jeweils in ein Paar gegenüber liegender Nuten, die sich auf derselben vertikalen Höhe befinden, eines der Energiespeichereinschübe eingeschoben sind.

Dabei können die Energiespeicher ohne Berücksichtigung der Befestigungsflansche eine horizontale Breite aufweisen, die im Wesentlichen einer lichten Breite der Energiespeichereinschübe entspricht, wobei die Energiespeicher eine vertikale Höhe aufweisen, die im Wesentlichen einem vertikalen Abstand der Nuten entspricht, so dass in vertikaler und horizontaler Richtung eine maximale Packungsdichte erreicht ist.

Weitere Einzelheiten der Erfindung werden anhand der nachstehenden Figuren erläutert. Dabei zeigt:
- Figur 1: in perspektivischer Darstellung einen Schaltschrank gemäß einer Ausführungsform der Erfindung;
- Figur 2.: eine Detailansicht des Schaltschranks gemäß Figur 1, der die Energiespeichereinschübe besser zeigt; und
- Figur 3: eine Detailansicht des Masseanschlusses der Ausführungsform gemäß den Figuren 1 und 2.

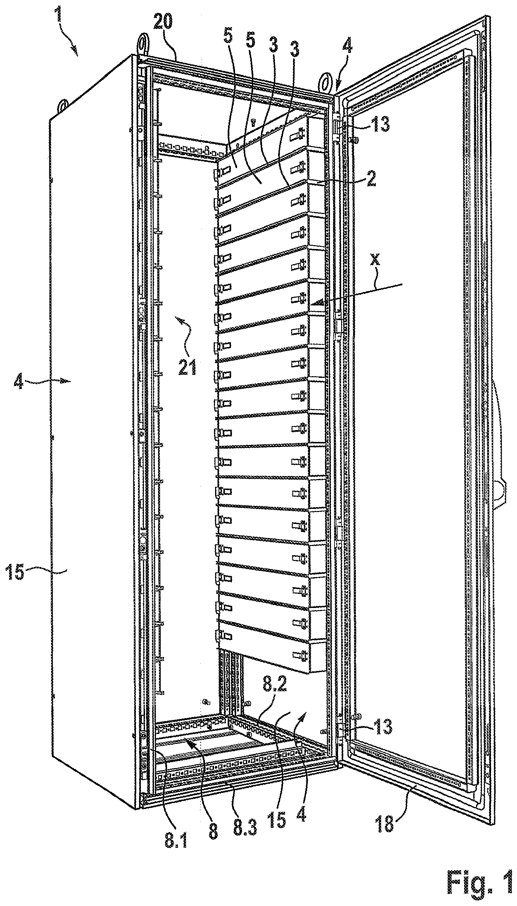

Figur 1 zeigt einen Schaltschrank 1 gemäß einer Ausführungsform der Erfindung. Der Schaltschrank 1 weist ein Rahmengestell 8 auf, das aus vier Vertikalstreben 8.1, vier Tiefenstreben 8.2 und vier Breitenstreben 8.3 gebildet ist. An den acht Eckpunkten des Rahmengestells 8 treffen jeweils eine Vertikalstrebe 8.1, eine Tiefenstrebe 8.2 und eine Breitenstrebe 8.3 rechtwinklig aufeinander. Das Rahmengestell ist an gegenüberliegenden Seiten 4 mit jeweils einem Seitenteil 15 verkleidet. Bodenseitig ist das Rahmengestell 8 von einer Bodenwanne 19, dachseitig von einem Dachelement 20 sowie rückwärtig über eine Rückwand 21 verkleidet. An der Vorderseite ist eine Schaltschranktür 18 an dem Rahmengestell 8 über Scharniere 13 verschwenkbar befestigt.

An den gegenüber liegenden Seiten 4 des Schaltschranks 1 ist innenseitig an den Seitenwänden 15 jeweils eine Vielzahl Montagechassis 5 vertikal übereinander montiert, die zwischen sich eine Mehrzahl Energiespeichereinschübe 2 mit Nuten 3 bilden, über die Energiespeicher von der türseitigen Vorderseite des Schaltschranks 1 aus in Tiefenrichtung x des Schaltschrank eingeschoben werden können.

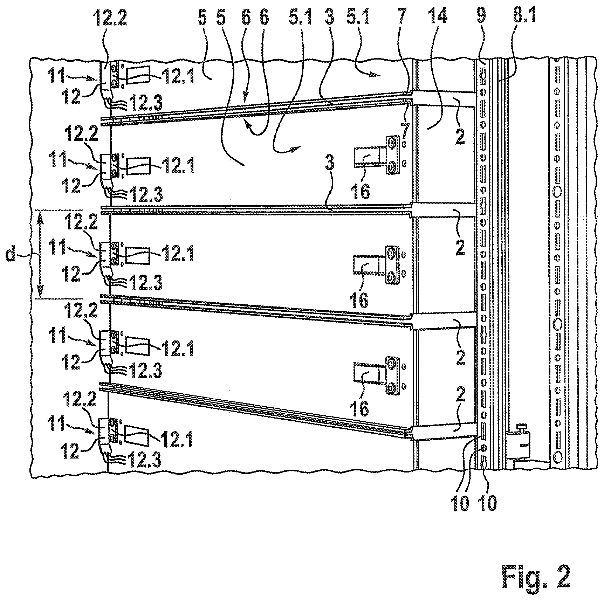

Die von den Montagechassis 5 gebildeten Energiespeichereinschübe 2 sind in Figur 2 näher gezeigt. Die Figur 2 lässt erkennen, dass die Montagechassis 5 an ihren sich in Längsrichtung erstreckenden Längsseiten 6 einen abgekanteten Anlageflansch 7 aufweisen, wobei zwischen den Anlageflanschen vertikal benachbarter Chassis 5 ein Abstand ausgebildet ist, der gerade die Nut 3 für den Einschub der Energiespeicher bildet.

Die Montagechassis sind im Wesentlichen als Blechformteile gebildet, wobei ein Mittelabschnitt 5.1, der parallel zu den Seiten 4 des Schaltschranks 1 ausgerichtet ist (vgl. Figur 1), über in Längsrichtung endseitige Stützabschnitte 14, die von dem Mittelabschnitt 5.1 abgekantet sind, an den Vertikalstreben 8.1 befestigt ist. Die Vertikalstreben 8.1 weisen dazu eine Montageseite 9 mit einer Systemlochung 10 aus regelmäßig beabstandeten Montageausnehmungen auf. Es ist insbesondere vorgesehen, dass das Montagechassis 5 ein Blechformteil aus elektrisch leitfahigem Material ist, wobei das Montagechassis 5 weiterhin elektrisch leitend mit den Vertikalstreben 8.1 verbunden ist und auch die Vertikalstreben 8.1 elektrisch leitfähig sind, so dass eine elektrisch leitfähige Verbindung zwischen den Montagechassis 5 und dem Rahmengestell 8 des Schaltschranks 1 hergestellt ist.

Von dem Mittelteil 5.1 sind Anlageflansche 7 an den Längsseiten 6 des Mittelteils 5.1 abgekantet, welche mit ihrem freien Ende in den Schaltschrankinnenraum hinein und in Richtung der gegenüber liegenden Montagechassis 5 erstrecken. Auf diese Weise bilden die benachbarten Anlageflansche 7 in Vertikalrichtung unmittelbar aufeinander folgender Montagechassis 5 zwischen sich eine Nut für den Einschub eines elektrischen Energiespeichers. An einem in Einschubrichtung vorderen Ende des Mittelteils 5.1 ist ein als Spange ausgebildetes Rastelement 16 angeordnet, mit Hilfe welches eine Rastposition des Energiespeichers festgelegt werden kann, in welcher sich der Energiespeicher in der vollständig eingeschobenen Position befindet und in dieser gegenüber einem ungewollten Verschieben in Einschubrichtung x gesichert ist.

Das Rastelement 16 ist für die werkzeuglose Montage und Demontage von Batterieeinschüben ausgelegt, wozu die Spange eine Anlaufschräge aufweist, die in einen Rastvorsprung übergeht, der durch Eindrücken der Anlaufschräge aus seiner Schließposition in eine Freigabeposition vorgespannt werden kann. Beim Einschieben eines Energiespeichermoduls wird die Anlaufschräge von einer Seitenwand des Energiespeichermoduls eingedrückt, so dass der Rastvorsprung an der Seitenwand vorbeigeführt werden kann. Wenn das Energiespeichermodul seine Endposition/Rastposition erreicht, kann die Spange aufgrund ihrer Vorspannung in die Schließposition übergehen, in der der Rastvorsprung in eine entsprechende Ausnehmung in der Seitenwand des Energiespeichermoduls eingreift und das Energiespeichermodul festlegt. Zum Wiederauslösen des Energiespeichermoduls kann die Anlaufschräge der Spange manuell betätigt werden, um den Rastvorsprung aus der Schließposition in die Freigabeposition zu überführen.

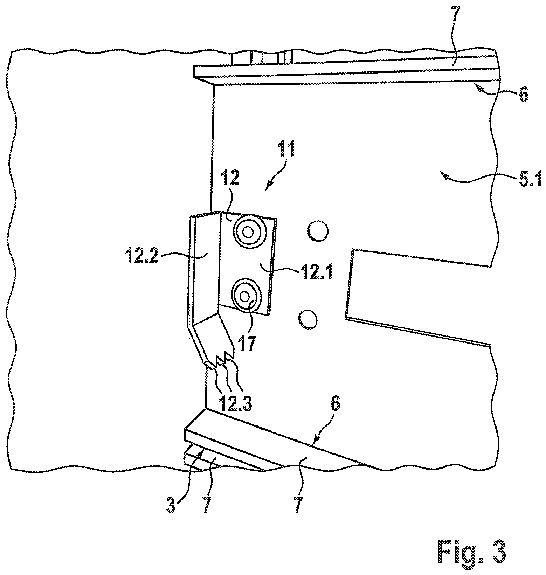

An dem gegenüber liegenden, rückwärtigen Ende des Mittelteils 5.1 des Montagechassis 5 ist ein Masseanschluss 11 angeordnet. Dieser ist in Figur 3 näher dargestellt. Der Masseanschluss 11 weist demgemäß ein elektrisch leitfähiges Kontaktblech 12 auf, das mit einem Befestigungsabschnitt 12.1 an dem Mittelteil 5.1 des Montagechassis festgelegt ist. Bei der Ausführungsform gemäß Figur 3 erfolgt dies mit Hilfe von zwei Nieten 17. Es ist jedoch jedes andere Befestigungsmittel geeignet, welches für eine elektrisch leitfähige Verbindung des Masseanschlusses 11 an dem Mittelteil 5.1 des Montagechassis 5 geeignet ist. Von dem Befestigungsabschnitt 12.1 erstreckt sich ein freies Ende 12.2 des Kontaktblechs 12, das gegenüber dem Befestigungsabschnitt 12.1 mechanisch vorspannbar ist und drei Kontaktkrallen 12.3 zur elektrischen Kontaktierung eines Massekontakts eines Energiespeichers aufweist.

Das Kontaktblech 12 kann als ein einfaches Blechformteil ausgebildet sein. Dabei ist die Position des freien Endes 12.2, insbesondere der Kontaktkrallen 12.3, derart ausgelegt, dass die Kontaktkrallen 12.3 im vollständig eingeschobenen Zustand eines elektrischen Energiespeichers den Massekontakt des Energiespeichers mechanisch vorgespannt kontaktieren.

### Bezugszeichenliste:

- 1: Schaltschrank
- 2: Energiespeichereinschub
- 3: Nut
- 4: Schaltschrankseite
- 5: Montagechassis
- 5.1: Mittelteil
- 6: Längsseite
- 7: Anlageflansch
- 8: Rahmengestell
- 8.1: Vertikalstrebe
- 8.2: Tiefenstrebe
- 8.3: Breitenstrebe
- 9: Montageseite
- 10: Systemlochung
- 11: Masseanschluss
- 12: Kontaktblech
- 12.1: Befestigungsabschnitt
- 12.2: freies Ende
- 12.3: Kontaktkralle
- 13: Scharnier
- 14: Stützabschnitt
- 15: Seitenteil
- 16: Rastelement
- 17: Niet
- 18: Schaltschranktür
- 19: Bodenwanne
- 20: Dachelement
- 21: Rückwand
- x: Einschubrichtung

## Patentansprüche

1. Schaltschrank (1) oder Rack zur Aufnahme elektrischer Energiespeicher, insbesondere Batterien, wobei der Schaltschrank (1) oder das Rack eine Mehrzahl übereinander angeordneter Energiespeichereinschübe (2) aufweist, die von einer Mehrzahl von Nuten (3) gebildet sind, deren Längs- und Einschubrichtung (x) sich in Tiefenrichtung des Schaltschranks (1) oder Racks erstreckt, und wobei jeweils ein Paar der Nuten (3) an gegenüber liegenden Seiten (4) des Schaltschranks (1) oder Racks auf derselben vertikalen Höhe und mit ihrer offenen Längsseite aufeinander zu gerichtet sind, **dadurch gekennzeichnet, dass** die Energiespeichereinschübe (2) jeweils an ihrem in Einschubrichtung hinteren Ende einen Masseanschluss (11) aufweisen, der einen Massekontakt eines Energiespeichers kontaktiert, wenn sich der betreffende Energiespeicher in einer vollständig eingeschobenen Position befindet, wobei der Schaltschrank oder das Rack weiterhin ein elektrisch leitfähiges Rahmengestell (8) aufweist, an dem die, ebenfalls elektrisch leitfähigen, Energiespeichereinschübe (2), insbesondere die die Energiespeichereinschübe (2) bildenden Montagechassis (5), montiert und elektrisch kontaktiert sind, wobei die Masseanschlüsse mit den Energiespeichereinschüben (2), insbesondere mit den Montagechassis(5), elektrisch kontaktiert sind.

2. Schaltschrank oder Rack nach Anspruch 1, bei dem die Energiespeichereinschübe (2) von einer Mehrzahl vertikal übereinander und an den gegenüber liegenden Seiten (4) des Schaltschranks (1) oder Racks montierten Montagechassis (5) gebildet sind, die unter einem vertikalen Abstand (d) zueinander montiert sind, der eine vertikale Nutbreite senkrecht zur Einschubrichtung (x) festlegt.

3. Schaltschrank oder Rack nach Anspruch 2, bei dem die Montagechassis (5) an ihren sich in Tiefenrichtung erstreckenden, parallelen Längsseiten (6) jeweils einen in Richtung der jeweils gegenüber liegenden Seite des Schaltschranks (1) oder Racks abgekanteten Anlageflansch (7) aufweisen.

4. Schaltschrank oder Rack nach Anspruch 3, bei dem die Anlageflansche (7) paarweise gegenüber liegender Montagechassis (5) auf derselben vertikalen Höhe (h) angeordnet sind, und wobei jeweils eine der Nuten (3) zwischen den abgekanteten Anlageflanschen (7) unmittelbar aufeinander folgender Montagechassis (5) gebildet ist.

5. Schaltschrank oder Rack nach einem der Ansprüche 2 bis 4, der/das weiterhin ein Rahmengestell (8) mit vier gleich langen Vertikalstreben (8.1) und vier gleich langen Tiefenstreben (8.2) aufweist, von denen jeweils zwei Vertikalstreben (8.1) und zwei Tiefenstreben (8.2) zu jeweils einem rechteckigen Rahmen verbunden sind, die die gegenüber liegenden Seiten (4) des Schaltschranks (1) oder Racks bilden, wobei die Vertikalstreben (8.1) an einer Montageseite (9) eine Systemlochung (10) aus regelmäßig beabstandeten Montageausnehmungen aufweisen, und wobei die Montagechassis (5) an gegenüber liegenden Enden mit jeweils einer der Vertikalstreben (8.1) eines der rechteckigen Rahmen verbunden sind.

6. Schaltschrank oder Rack nach Anspruch 1, bei dem der Masseanschluss (11) ein elektrisch leitfähiges Kontaktblech (12) mit einem Befestigungsabschnitt (12.1) aufweist, über den das Kontaktblech (12) an einem der Montagechassis (5) elektrisch leitfähig festgelegt ist, wobei das Kontaktblech (12) weiterhin ein freies Ende (12.2) aufweist, das gegenüber dem Befestigungsabschnitt (12.1) mechanisch vorspannbar ist und mindestens eine Kontaktkralle (12.3) zur elektrischen Kontaktierung des Massekontaktes des Energiespeichers aufweist.

7. Schaltschrank oder Rack nach Anspruch 6, bei dem die Energiespeichereinschübe (2) jeweils eine Rastposition aufweisen, die eine vollständig eingeschobene Position eines Energiespeichers festlegt, wobei in der Rastposition das freie Ende (12.2) des Kontaktblechs (12) über die mindestens eine Kontaktkralle (12.3) an dem Massekontakt des Energiespeichers mechanisch vorgespannt anliegt, um den Masseanschluss (11) elektrisch zu kontaktieren.

8. Schaltschrank oder Rack nach Anspruch 19, bei dem das Rahmengestell (8) aus unlackierten, elektrisch leitfähiges Streben (8.1, 8.2), oder aus unlackierten, elektrisch leitfähig beschichteten, insbesondere verzinkten, Streben (8.1, 8.2) gebildet ist.

9. Schaltschrank- oder Rackanordnung mit einem Schaltschrank (1) oder Rack nach einem der vorangegangen Ansprüche sowie einer Mehrzahl elektrischer Energiespeicher, wobei die elektrischen Energiespeicher an gegenüber liegenden Seiten jeweils einen sich in Tiefenrichtung des Energiespeichers erstreckenden Befestigungsflansch aufweisen, über den die elektrischen Energiespeicher jeweils in ein Paar gegenüber liegender Nuten (3) eines der Energiespeichereinschübe (2) eingeschoben sind.

10. Schaltschrank- oder Rackanordnung nach Anspruch 9, bei der die Energiespeicher ohne Berücksichtigung der Befestigungsflansche eine horizontale Breite aufweisen, die im Wesentlichen einer lichten Breite der Energiespeichereinschübe (2) entspricht, und wobei die Energiespeicher eine vertikale Höhe aufweisen, die im Wesentlichen einem vertikalen Abstand (d) der Nuten entspricht, so dass in vertikaler und horizontaler Richtung eine maximale Packungsdichte erreicht ist.

## Claims

1. Switch cabinet (1) or rack for receiving electrical energy storage units, in particular batteries, wherein the switch cabinet (1) or the rack has a plurality of energy storage unit slots (2) arranged above one another, wherein the energy storage unit slots (2) are formed by a plurality of grooves (3), whose longitudinal and slide-in direction (x) extends in the depth direction of the switch cabinet (1) or rack, and wherein in each case a pair of grooves (3) is set up on the opposite lying sides (4) of the switch cabinet (1) or rack at the same vertical height and with the open longitudinal side directed toward one another, **characterized in that** the energy storage unit slots (2) in each case have a ground contact (11) in their back end in the slide-in direction, which contacts a ground contact of an energy storage unit, whenever the particular energy storage unit is in a completely slid-in position, wherein the switch cabinet or the rack also has an electric conducting frame structure (8), to which the also electrically conducting energy storage unit slots (2), in particular the mounting chassis (5) forming the energy storage unit slots, (2) are assembled and electrically contacted, wherein the ground connections are in electrical contact with the energy storage unit slots (2), in particular with the mounting chassis (5).

2. Switch cabinet or rack according to claim 1, in which the energy storage unit slots (2) are formed by a plurality of mounting chassis (5) which are mounted vertically one above the other and on the opposite sides (4) of the switch cabinet (1) or rack, which are mounted at a vertical distance (d) from one another that determines a groove width perpendicular to the slide-in direction (x).

3. Switch cabinet or rack according to claim 2, in which the mounting chassis (5) on their parallel longitudinal sides (6) extending in the depth direction in each case have a beveled unit flange (7) in the direction of the particular opposite lying side of the switch cabinet (1) or rack.

4. Switch cabinet or rack according to claim 3, in which the unit flanges (7) of mounting chassis (5) lying in pairs opposite one another are arranged at the same vertical height (h), and wherein in each case one of the grooves (3) between the beveled unit flanges (7) is formed directly above the following mounting chassis (5).

5. Switch cabinet or rack according to one of claims 2 to 4, which also has a frame structure (8) with four equally long vertical ledges (8.1) and four equally long depth edges (8.2), from which in each case two vertical ledges (8.1) and two depth ledges (8.2) are connected in each case to a rectangular frame, which form the opposite lying sides (4) of the switch cabinet (1) or rack, wherein the vertical ledges (8.1) have on a mounting side (9) a system of holes (10) of mounting recesses at a regular distance from one another, and wherein the mounting chassis (5) are attached to the opposite lying ends with in each case one of the vertical ledges (8.1) of one of the rectangular frames.

6. Switch cabinet and or rack according to claim 1, in which the ground connection (11) has an electric conducting contact plate (12) with a fastening section (12.1), through which the contact plate (12) is attached electrically conducting to one of the mounting chassis (5), wherein the contact plate (12) also has a free end (12.2), which is mechanically preloaded with respect to the fastening section (12.1) and which has at least one contact claw (12.3) for electrical contact of the ground contact of the energy storage unit.

7. Switch cabinet or rack according to claim 6, in which the energy storage unit slots (2) each have a retaining position, which determines a completely slid-in position of an energy storage unit, wherein in the retaining position the free end (12.2) of the contact plate (12) abuts mechanically preloaded the ground contact of the energy storage unit via the at least one contact claw (12.3), in order to electrically contact the ground connection (11).

8. Switch cabinet or rack according to claim 1 in which the frame structure (8) is made of unlacquered, electrically conducting ledges (8.1, 8.2), or of unlacquered, electrically conducting coated ledges (8.1, 8.2), in particular galvanized ones.

9. Switch rack or rack set up with a switch cabinet (1) or rack according to one of the prior claims and a plurality of electrical energy storage units, wherein the electrical energy storage units have on opposite sides in each case a fastening flange stretching in the depth direction of the energy storage unit, through which the electrical energy storage units in each case are slid in on a pair of opposite lying grooves (3) of one of the energy storage unit slots (2).

10. Switch cabinet or rack set up according to claim 9, in which the energy storage units have a horizontal width without consideration of the fastening flanges, which essentially corresponds to a clear width of the energy storage unit slots (2), and wherein the energy storage units have a vertical height that essentially corresponds to a vertical distance (d) of the grooves, so that a maximum packing density in the vertical and horizontal direction is achieved.

## Revendications

1. Armoire de commande (1) ou rack pour le logement d'accumulateurs d'énergie, plus particulièrement des batteries, l'armoire de commande (1) ou le rack comprenant une pluralité de tiroirs à accumulateurs d'énergie (2) superposés, qui sont constitué d'une pluralité de rainures (3), dont la direction longitudinale et d'insertion (x) s'étend dans la direction de la profondeur de l'armoire de commande (1) ou du rack et une paire de rainures (3), au niveau de côtés (4) opposés de l'armoire de commande (1) ou du rack, étant disposée à la même hauteur verticale et orientée l'une vers l'autre avec leur côté longitudinal ouvert, **caractérisée en ce que** les tiroirs à accumulateurs d'énergie (2) comprennent chacun, au niveau de leur extrémité arrière dans la direction d'insertion, un raccordement à la masse (11), qui met en contact un contact de masse d'un accumulateur d'énergie lorsque l'accumulateur d'énergie concerné se trouve dans une position entièrement insérée, l'armoire de commande ou le rack comprenant en outre une baie (8) électriquement conductrice, au niveau de laquelle les tiroirs à accumulateurs d'énergie (2), également électriquement conducteurs, plus particulièrement les châssis de montage (5), constituant les tiroirs à accumulateurs d'énergie (2), sont montés et mis en contact électrique, les raccordements à la masse étant mis en contact électrique avec les tiroirs à accumulateurs d'énergie (2), plus particulièrement le châssis de montage (5).

2. Armoire de commande ou rack selon la revendication 1, dans laquelle les tiroirs à accumulateurs d'énergie (2) sont constitués d'une pluralité de châssis de montage (5) montés verticalement les uns sur les autres ou montés sur les côtés (4) opposés de l'armoire de commande (1) ou du rack, qui sont montés avec une distance verticale (d) entre eux qui détermine une largeur de rainure perpendiculairement à la direction d'insertion (x).

3. Armoire de commande ou rack selon la revendication 2, dans laquelle les châssis de montage (5) comprennent chacun, au niveau de leurs côtés longitudinaux (6) parallèles s'étendant dans la direction de la profondeur, une bride d'appui (7) chanfreinée dans la direction du côté opposé de l'armoire de commande (1) ou du rack.

4. Armoire de commande ou rack selon la revendication 3, dans laquelle les brides d'appui (7) de châssis de montage (5) opposés par paires sont disposées sur la même hauteur verticale (h) et une des rainures (3) étant formée entre les brides d'appui (7) chanfreinée de châssis de montage (5) directement adjacents.

5. Armoire de commande ou rack selon l'une des revendications 2 à 4, qui comprend en outre une baie (8) avec quatre entretoises verticales (8.1) de même longueur et quatre entretoises de profondeur (8.2) de même longueur, dont deux entretoises verticales (8.1) et deux entretoises de profondeur (8.2) sont reliées afin d'obtenir un cadre rectangulaire, qui constituent les côtés (4) opposés de l'armoire de commande (1) ou du rack, les entretoises verticales (8.1) comprenant, au niveau d'un côté de montage (9), une perforation de système (10) constituée d'évidements de montage réalisés à intervalles réguliers, et les châssis de montage (5) étant reliés chacun, au niveau d'extrémités opposées, avec une des entretoises verticales (8.1) d'un des cadres rectangulaires.

6. Armoire de commande ou rack selon la revendication 1, dans laquelle le raccordement à la masse (11) comprend une tôle de contact (12) électriquement conductrice avec une portion de fixation (12.1), par l'intermédiaire de laquelle la tôle de contact (12) est fixée de manière électriquement conductrice à un des châssis de montage (5), la tôle de contact (12) comprenant en outre une extrémité libre (12.2) qui peut être précontrainte mécaniquement par rapport à la portion de fixation (12.1) et au moins une griffe de contact (12.3) pour la mise en contact électrique du contact de masse de l'accumulateur d'énergie.

7. Armoire de commande ou rack selon la revendication 6, dans laquelle les tiroirs à accumulateurs d'énergie (2) comprennent chacun une position d'encliquetage qui détermine une position entièrement insérée d'un accumulateur d'énergie, moyennant quoi, dans la position d'encliquetage, l'extrémité libre (12.2) de la tôle de contact (12) s'appuie de manière mécaniquement précontrainte, par l'intermédiaire de l'au moins une griffe de contact (12.3), contre le contact de masse de l'accumulateur d'énergie, afin de mettre en contact électrique le raccordement à la masse (11).

8. Armoire de commande ou rack selon la revendication 1, dans laquelle la baie (8) est constituée d'entretoises (8.1, 8.2) non peintes et électriquement conductrices ou d'entretoises (8.1, 8.2) non peintes munies d'un revêtement électriquement conducteur, plus particulièrement zinguées.

9. Disposition d'armoire de commande ou de rack avec une armoire de commande (1) ou un rack selon l'une des revendications précédentes ainsi qu'une pluralité d'accumulateurs d'énergie électrique, les accumulateurs d'énergie électrique comprenant chacun, au niveau de côtés opposés, une bride de fixation s'étendant la direction de la profondeur de l'accumulateur d'énergie, par l'intermédiaire de laquelle les accumulateurs d'énergie sont insérés chacun dans une paire de rainures (3) opposées d'un des tiroirs à accumulateurs d'énergie (2).

10. Disposition d'armoire de commande ou de rack selon la revendication 9, dans laquelle les accumulateurs d'énergie présentent, sans tenir compte de la bride de fixation une largeur horizontale qui correspond globalement à une largeur libre des tiroirs à accumulateurs d'énergie (2) et les accumulateurs d'énergie présentant une hauteur verticale qui correspond globalement à une distance verticale (d) des rainures, de façon à ce que, dans les directions verticale et horizontale, une compacité maximale soit obtenue.
